# EUROPEAN PATENT APPLICATION

(11) **EP 0 571 633 A1**
(43) Date of publication of application: **01.12.1993**
(21) Application number: 92923567.9
(22) Date of filing: 13.11.1992
(51) Int. Cl.: H01L 39/22

(54) **SUPERCONDUCTIVE ELEMENT**

(30) Priority: 13.11.1991 JP 297417/91; 22.01.1992 JP 9544/92; 06.03.1992 JP 49899/92; 10.03.1992 JP 51596/92; 16.04.1992 JP 96598/92
(71) Applicant: SEIKO EPSON CORPORATION, Shinjuku-ku Tokyo 163 (JP)
(72) Inventor: KAMIKAWA, Taketomi Seiko Epson Corporation, Suwa-shi Nagano-ken 392 (JP); NATORI, Eiji Seiko Epson Corporation, Suwa-shi Nagano-ken 392 (JP); IWASHITA, Setsuya Seiko Epson Corporation, Suwa-shi Nagano-ken 392 (JP); SHIMODA, Tatsuya Seiko Epson Corporation, Suwa-shi Nagano-ken 392 (JP)
(74) Representative: Hoffmann, Eckart, Dipl.-Ing.
(86) International application number: PCT/JP92/01484
(87) International publication number: WO 93/10565

(57) **Abstract**

A superconductive element provided with a first and a second superconductive electrode, and a connector which is made of a superconductive material and which is for connecting the first and second superconductive electrodes. The superconductive element is a two-terminal or a three-terminal superconductive element using the connector which is in a weaker superconductive state than that of the first and second superconductive electrodes or is in a normal conductive state close to the superconductive state. As a means for bringing the connector to the foregoing state, utilized are the differences of the connector and the first and second superconductive electrodes in critical current, in critical temperature, in pair potential, or in carrier density. Thus the restrictions on pattern rules are small and its manufacturing is easy. In cases of a three-terminal superconductive element, its switching characteristic can be improved too.

## Description

### Technical Field

This invention concerns a superconductive device that is used in components such as a switch, a memory device, a SQUID, an electromagnetic wave detector and a voltage reference.

### Background Technology

A superconductive device allows a variety of applications in the electronics field because it has peculiar properties both electrically and magnetically and because it operates at a high speed and at a low power consumption. A great deal of superconductive device research and development has taken place to date. In particular, since the discovery of the oxide superconductor, which has a high critical temperature, the problems of large-scale cooling equipment and running costs have been resolved, and this has led to the current day, in which research and development is being spurred even more.

In general, the basic components forming the superconductive device are two superconductive electrodes and a junction that links these two electrodes. This is true of a 2-terminal superconductive device and a 3-terminal superconductive device.

In general, an insulator, a semiconductor or a normal conductor is used as the junction. However, even if a superconductive material is used, in many cases, the operating temperature of the device is set to a temperature that is much higher than the critical temperature of the material and the material is often used as a perfect normal conductor.

The nature of such a prior-art superconductive device is in the weak superconductive link that couples the two superconductive electrodes in a weak manner through the junction. The reasons for the appearance of a weak superconductive link in the case of a junction made of an insulator or some semiconductors is the tunnel effect. Or, in the case of a junction made of some other semiconductors, normal conductors or superconductive materials, the reason is the superconductive state penetration effect. In other words, it is the proximity effect.

In addition to the examples of the prior art described above, in the case of the 3-terminal superconductive device in particular, there are the two examples of the prior art indicated below. As disclosed in patent number 1-207982, one is the 3-terminal superconductive device of the prior art that uses superconductive material that is in a superconductive state, as the junction and modulates the current that flows between the superconductive electrodes through the application of a signal voltage to the control electrode that is attached to the junction.

In this prior-art example, the junction functions as both the first and the second superconductive electrodes. In other words, the first and the second superconductive electrodes and the junction are formed of the same superconductive material. The nature of the functioning of such superconductive devices is neither in the tunnel effect nor in the proximity effect. It is in the destruction of the zero electrical resistance state at a current flow where the junction is at a value above the critical current flow, and, as a result of the signal voltage, it is in the formation of a depletion layer on the junction and in the junction functioning as a channel.

As disclosed in patent numbers 63-234572, 63-234573 and 63-234574, another example is the 3-terminal superconductive device of the prior art which is made to operate at an intermediate temperature between Tc onset and Tc0, in which the junction that will become the channel is made of a superconductive material which has a large temperature difference between Tc [onset] (the temperature at which superconductivity begins) and Tc0 (the temperature at which the electrical resistance becomes zero).

However, for the superconductive devices of the prior art, which are based on the tunnel effect or the proximity effect, the drawback is that the junction has to be an extremely thin film of a few hundred nanometers or less or the drawback is that it cannot adequately demonstrate its functions unless it is an extremely fine line pattern. Whether it is the tunnel effect or the proximity effect, the reason for this is that the length at which these functions appear is from the tens of nanometers to the hundreds of nanometers in the case of the materials used for the superconductive devices in the prior art and in the case of the operating environment.

In the case of the proximity effect in particular, generally the penetration length has a close relationship to the junction coherence length, and both are to be the same length. However, the coherence length of the oxide high temperature superconductive device is shorter than that of a metal superconductor. As a result, for a superconductive device that uses the proximity effect of an oxide high temperature superconductor, it is necessary to make the size of the junction a few nm or less. To make the channel this size is an extremely difficult technology in terms of both thin-film technology and photolithography technology.

Further, for a 3-terminal superconductive device in which a control electrode is attached to the junction, the restrictions on the size of the channel become the restrictions of the region where to attach the control electrode, which creates even greater difficulties. As is clear from the description above, restricting the size of the junction to a few hundred nanometers or restricting it to a few nanometers will become a major negative factor on the production yield, the reliability, and the reproduceability and uniformity of the superconductive device. In particular, in the case of an oxide high temperature superconductor, the restrictions on the size of the junction become more stringent for the reasons already given. Moreover, because a valuable advantage cannot be applied, that is, the advantage of possessing a high critical temperature, this must be considered a major drawback.

Furthermore, if described in terms of the 3-terminal superconductive device of the prior art described in patent number Hei 1-207982, a device that uses the junction in the superconductive state, the problem is one of obtaining good size characteristics. The reason for this is that it is difficult to use the junction as a channel and form a depletion layer that is thick enough to create a clear on/off status. In order to obtain a depletion layer of sufficient thickness, it is necessary to use a signal voltage that is too high to be practical as the operating voltage of the superconductive device, or it is necessary to have the film thickness of the junction be so thin that its superconductive characteristics will break down.

Moreover, in the prior-art examples of the 3-terminal superconductive devices disclosed in patent numbers 63-234572, 63-234573 and 63-234574, because the channel is used in a resistive superconductive state, it is necessary to apply a non-zero voltage to the channel, and this has the drawback of not allowing the use of superconductive current, which is a benefit of the superconductive device. From the point of view of material technology, a superconductive material in which the temperature difference is large between Tc onset and Tc0 is a low-quality material that lacks reliability and stability and is impractical.

This invention solves these problems. It has few restrictions concerning the thickness of the thin film and the pattern rule. It also is easy to produce, and it has high yield and high reliability. Moreover, it is possible to form the junction of an excellent superconductive material and offer a superconductive device that is able to utilize superconductive current that flows at zero voltage. In addition to the characteristics described above, in the case of the 3-terminal superconductive device, this invention especially offers a superconductive device that has excellent switching characteristics.

### Disclosure of the Invention

This invention comprises a first superconductive electrode, a second superconductive electrode and a junction that links these superconductive electrodes. In the case of a superconductive device in which the junction is formed from a superconductive material, a superconductive state that is weaker than the first and the second superconductor electrodes or a normal conductor state that is near the superconductive state is used on the junction. As a result of this, there are few restrictions concerning the thickness of the thin film, production is simple, and this will improve production yield and reliability. Thus, the superconductive device that is obtained has a junction made of an excellent superconductive material and utilizes a superconductive current that flows at zero voltage.

In addition, by forming a control electrode adjacent to the junction and using the junction as a channel, it is possible to obtain a 3-terminal superconductive device with excellent switching characteristics.

As a means of causing a superconductive state that is weaker than the first and the second superconductive electrodes or causing an ordinary conductive state that is near the superconductive state, the methods utilized lower the critical temperature of the junction below the critical temperature of the first and the second superconductive electrodes, reduce the carrier density of the junction below the carrier density of the first and the second superconductive electrodes, and make the magnitude of the pair potential of the junction smaller than the magnitude of the pair potential of the first and the second superconductive electrodes.

The switching characteristics and reliability will increase further by forming the junction and the first and the second superconductive electrodes of an oxide superconductive material, by having the carrier density of the junction be from 10¹⁹ to 10²⁰/cm³, by selecting a combination of materials with a junction crystal structure that differs from the crystal structures of the first and the second superconductive electrodes, and by setting the operating temperature within the temperature range of the junction critical temperature ±5K.

### Brief Description of the Drawings

- Figure 1: shows an angular cross section of the 2-terminal superconductive device of this invention.
- Figure 2: shows the temperature characteristics of the specific resistances of the superconductor used in this invention.
- Figure 3: shows one example of the I/V characteristics of the 2-terminal superconductive device.
- Figure 4: shows the relationship between the distance d between the first and the second superconductive electrodes and critical current Ic.
- Figure 5: shows an angular cross section of the 3-terminal superconductive device of this invention.
- Figure 6: shows one example of the control electrode voltage dependency of the I/V characteristics of the 3-terminal superconductive device.
- Figure 7: shows the relationship between the operating temperature T and the critical current Ic that flows between the first and the second superconductive electrodes.
- Figure 8: shows the relationship between the operating temperature T and the switching ratio.
- Figure 9: shows an angular cross section of the 3-terminal superconductive device from the method that creates a difference in the carrier density.

### The Best Mode of Implementing the Invention

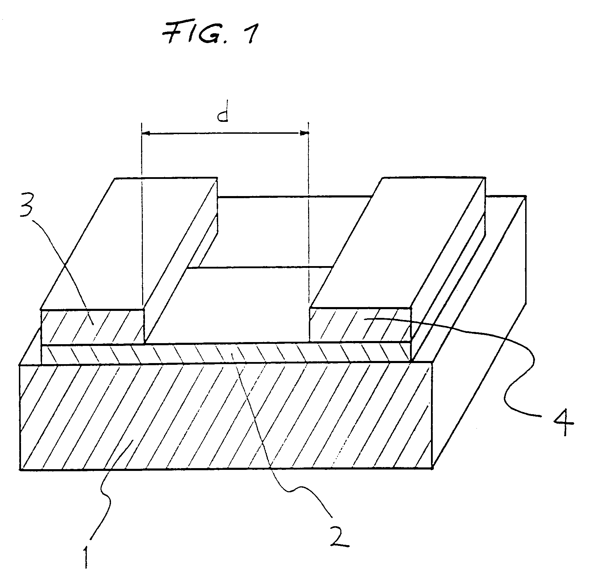

Figure 1 shows an angular cross section of a 2-terminal superconductive device. The superconductive device is formed on the substrate 1 and composed of a junction 2, the first superconductive electrode 3 and the second superconductive electrode 4. Symbol d in Figure 1 represents the distance between the first superconductive electrode and the second superconductive electrode. If stated in terms of the materials, the substrate 1 is made of SrTiO₃ single crystal, the junction 2 is made of YBa₂Cu₃O₇₋ₓ (0.2 ≦ x ≦ 0.5), and the first superconductive electrode 3 and the second superconductive electrode 4 are made of YBa₂Cu₃O_{7-y} (0 ≦ y < 0.2).

The method of producing this superconductive electrode is as follows. Molecular beam epitaxy (MBE) is used to form the junction 2, which is YBa₂Cu₃O₇₋ₓ (0.2 ≦ x ≦ 0.5) at a thickness of 100 nm on the substrate 1. Following this, the first superconductive electrode 3 and the second superconductive electrode 4, which are YBa₂Cu₃O_{7-y} (0 ≦ y < 0.2), are formed at a thickness of 100 nm. The oxidation of the thin film takes place during MBE by using an electron cyclotron resonance (ECR) plasma generating apparatus to introduce activated oxygen at the same time that the film is formed. After that, patterning takes place to obtain a 2-terminal superconductive device with the structure shown in Figure 1.

In the production method described above, the control of the degree of oxidation that is represented by the indicators x and y is possible by adjusting the oxygen gas pressure and flow rate as well as by adjusting the concentration of activated oxygen by the ECR plasma generating apparatus, or by adjusting the deposition rate. In order to have (0.2 ≦ x ≦ 0.5) and (0 ≦ y < 0.2), YBa₂Cu₃O₇₋ₓ becomes a 70K class superconductor and YBa₂Cu₃O_{7-y} becomes a 90K class superconductor. The reason the critical temperature can be controlled by the controlling the degree of oxygen in this manner is that the physical properties of the oxide superconductor is essentially related to the degree of oxygen doping. When the value of oxygen indicators x or y is near 0.2, the critical temperature becomes an intermediate temperature between 70K and 90K.

Moreover, when x is in the proximity of 0.5, the critical temperature becomes smaller than 70K. If the degree of oxidation is smaller than 0.5, the critical temperature decreases and ultimately no longer demonstrates superconductivity. As a result, in order to make the critical temperature of the junction 70K or in order to make the critical temperature of the first and the second superconductive electrodes 90K, it is desirable to have the indicators x and y be 0.25 ≦ x ≦ 0.4 and 0 ≦ y ≦ 0.15, respectively. In this embodiment, the same YBCO type substance is used for the junction and the first and the second superconductive electrodes. Therefore, continuous deposition is possible, and this is favorable in terms of thin film deposition technology. In addition, the lattice constants of YBa₂Cu₃O₇₋ₓ (0.2 ≦ x ≦ 0.5) and YBa₂Cu₃O_{7-y} (0 ≦ y < 0.2) are about the same. This is good in terms of the thin film epitaxial growth technology.

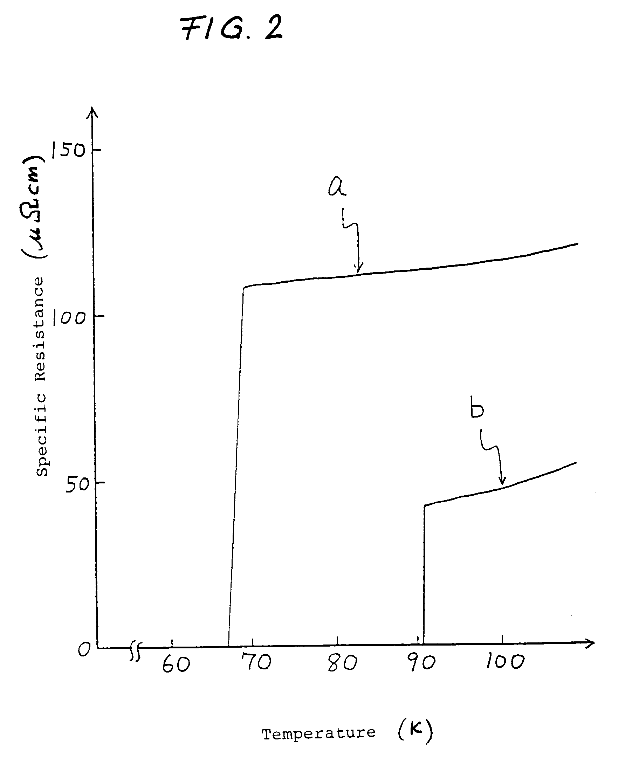

Figure 2 shows the temperature characteristics of the specific resistance of the superconductor used in this embodiment. The curve indicated by **a** in Figure 2 is the temperature characteristics of the specific resistance of the junction. The curve indicated by **b** in Figure 2 is the temperature characteristics of the specific resistance of the first and the second superconductive electrodes. As shown in Figure 2, the temperature difference between the junction and the first and second superconductive electrodes is several K below Tc onset and Tc0. This temperature difference is a small value for an oxide superconductor and indicates that both films are excellent quality superconductive thin films.

An experiment took place with samples that were fabricated with distances **d** between the first and the second superconductive electrodes set to the values listed in Table 1.

**Table 1**

| d (nm) | | | | |
|---|---|---|---|---|
| 200 | 500 | 1000 | 1500 | 2000 |
| 2500 | 3000 | 4000 | 5000 | 6000 |

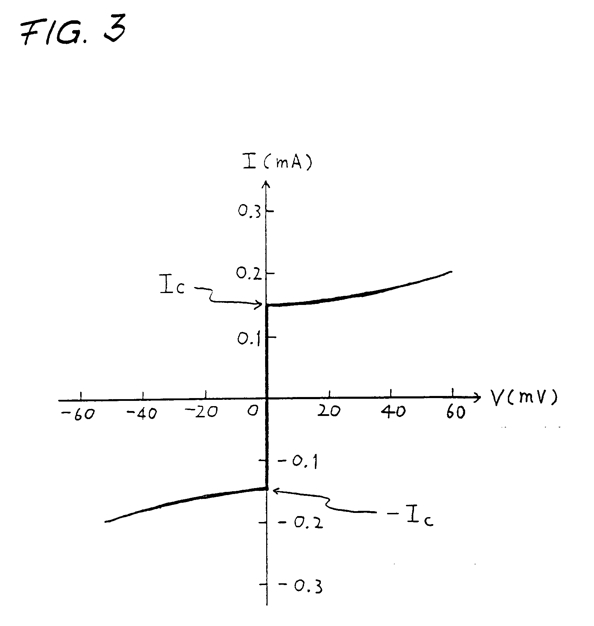

For each test sample, the I/V characteristics between the first and the second superconductive electrodes were measured at operating temperatures of 50K, 60K and 77K. Figure 3 shows one example of the I/V characteristics for the 2-terminal superconductive device. Symbol Ic in Figure 3 indicates the critical current. Zero voltage superconductive current flows in the current region from -Ic to +Ic. In current regions other than this, voltage is generated. In other words, the I/V characteristics shown in Figure 3 show the characteristics of a resistivity shunted junction (RSJ).

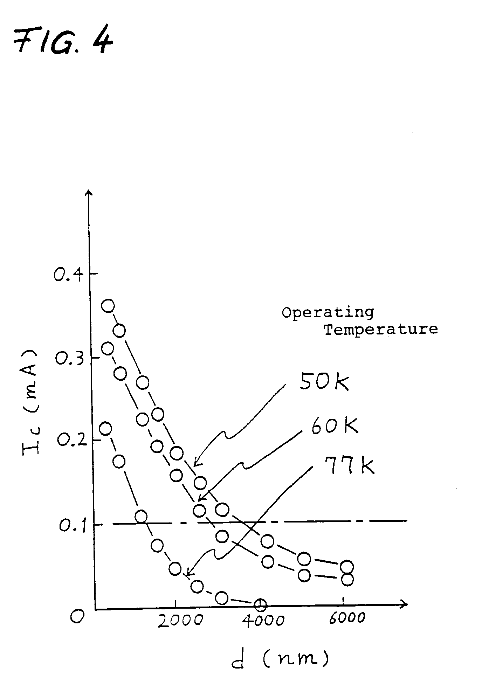

Figure 4 shows the relationship between distance **d** between the first and the second superconductive electrodes and the critical current Ic. As shown in Figure 4, when the operating temperature is lower than the 70K critical temperature of the junction, all samples gain the characteristic in which there is zero voltage superconductive current. In addition, when the operating temperature is 77K, which is higher than the 70K critical temperature of the junction, samples that are smaller than 3000 nm will gain characteristics in which there is superconductive current at zero voltage.

If the superconductive device is actually operated, and if a critical current of 1 mA or more is required, the minimum value of d is, for example, about 3000 nm at 50K operation and about 1000 nm at 77K operation. The values of d are sizes that can be easily patterned with existing photolithography, or sizes that can be patterned without accompanying technical difficulties.

Here, the reasons for obtaining RSJ characteristics for all of the samples at an operating temperature that is lower than the critical temperature of the junction, and the reason for obtaining RSJ characteristics for the samples that have a comparatively large d value and in which patterning is possible using photolithography are as indicated in the following.

The reason for an operating temperature that is lower than the critical temperature of the junction is as follows. A superconductor made of YBa₂Cu₃O₇₋ₓ (0.2 ≦ x ≦ 0.5) enters the superconductive state as a result of this operating temperature. However, this critical current density is smaller than that of the first and the second superconductive electrodes, which are made of YBa₂Cu₃O_{7-y} (0 ≦ y < 0.2). For this reason, when current goes through a superconductive device that has the structure of this embodiment, the phenomena described below take place.

First, in a case in which the operating temperature is smaller than the critical temperature of the junction, superconductive current will flow. It has no relationship to the distance **d**. In principle, it will flow no matter how long d is. Next, the case in which the magnitude of the current exceeds that of the critical current of the junction will be considered. This case will be further divided in two according to the magnitude of the current. In the first case, a current that is slightly larger than the critical current of the junction is allowed to flow. In the second case, a current that is larger than the current in the first case is allowed to flow.

In the first case, in spite of the fact that when the junction is a single unit, the superconductive state is broken, the superconductive state of the junction will be maintained due to the proximity effect that is caused by the first and the second superconductive electrodes being adjacent to each other.

As a consequence, in this case, superconductive current will flow in the same manner as the case in which current that is smaller than the critical current of the junction is allowed to flow. However, in the experimental criteria of this embodiment, because d is long enough to allow the proximity effect to operate effectively, the region of the superconductive current that corresponds to the first case is limited to a small range.

In the second case, the superconductive state of the junction is completely broken and the voltage is generated between the first and the second superconductive electrodes. To summarize the preceding, superconductive current will flow up to the critical current Ic, and at currents higher than that, voltage will be generated. This can be described as attaining the RSJ characteristics. However, as is clear from the preceding discussion, strictly speaking, Ic is a value that is larger than the critical current of the junction as a single unit.

Next, the reason for the operating temperature of the junction being higher than the critical temperature will be discussed. A junction that is made of YBa₂Cu₃O₇₋ₓ (0.2 ≦ x ≦ 0.5) will enter the superconductive state at the operating temperature as a single unit. However, because the junction makes contact with the first and the second superconductive electrodes, the superconductive state penetrates the inside of the junction due to the proximity effect. As a result, for the junction, the region reached by the proximity effect will become superconductive even at an operating temperature that is higher than the critical temperature.

However, the penetration will attenuate as the contact surfaces with the first and the second superconductive electrodes separate inside of the junction. According to the Ginzburg-Landau theory, the condition of this attenuation depends on temperature. That is, the closer to the critical temperature, the smaller the degree of attenuation and the longer the penetration depth. And in the case of the critical temperature, the depth becomes infinite.

As a result, although the operating temperature is higher than the critical temperature, if the former temperature is sufficiently close to the latter temperature, the proximity effect will be effective for a sufficiently long distance. The foregoing is the reason that an adequate proximity effect can be obtained even if distance **d** is comparatively large. Based on this reason, if the operating temperature of the superconductive device is higher than the critical temperature of the junction, the closer these temperatures are, i.e. if the ratio of the operating temperature to the critical temperature is greater than 1 the closer this ratio is to 1, the greater the distancs **d** is allowed to be, which is an advantage in terms of patterning.

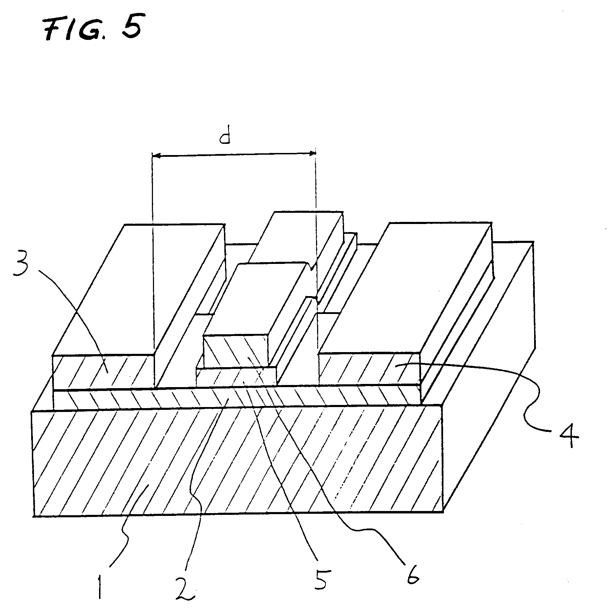

After the structure of the 2-terminal superconductive device described above has been fabricated, a dielectric and a control electrode are formed and patterned to fabricate a 3-terminal superconductive device. Figure 5 shows an angular cross section of the 3-terminal superconductive device of this invention. This superconductive device comprises a substrate 1, a junction 2, the first superconductive electrode 3, the second superconductive electrode 4, a dielectric 5 and a control electrode 6. The values for distance **d** are exactly the same as those shown in Table 1.

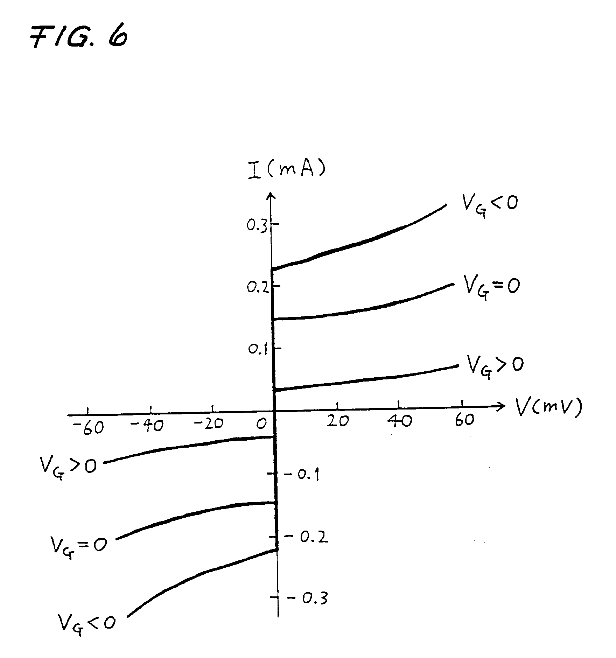

In the case of this superconductive device, the I/V characteristics of the current that flows between the first and the second superconductive electrodes is controlled by the voltage applied to the control electrode to modulate the current. The modulation characteristics of each sample was measured at 50K, 60K and 77K. Figure 6 shows one example of the control electrode voltage dependency of the I/V characteristics for the 3-terminal superconductive device. Symbol V_{G} in the drawing represents the control electrode voltage. As shown in Figure 6, the I/V characteristics can be controlled by the voltage applied to the control electrode.

When the control voltage is positive, the value of the critical current decreases as the control value increases. When the control voltage is negative, the value of the critical current increases as the absolute value increases. These modulation characteristics were obtained for all samples at an operating temperature that was lower than the 70K critical temperature of the junction as well as obtained for samples in which the distance **d** was smaller than 3000 nm, even at a 77K operating temperature, which is higher than the 70K critical temperature of the junction.

Moreover, for other samples in which superconductive current does not flow, the results gained were that the I/V characteristics in the voltage generating region can be controlled by the voltage applied to the control electrode. The reason that such control is possible is that the dielectric 5 is polarized by the applied voltage. As a result, the carrier density of the junction 2 will be modulated. That is, the junction will function as a channel, in the case of a 3-terminal superconductive device.

In the above, a class of junction with a critical temperature of 70K was used. However, the critical temperature of the junction can be controlled by adjusting the concentzration of oxygen x. For this reason, when a sample that used a junction with several types of critical temperatures, from 60K to 70K, was fabricated and the control electrode dependency of the I/V characteristics were evaluated, the I/V characteristics for all of the samples could be controlled by means of the voltage the I/V characteristics applied to the control electrode.

If this invention is applied to such a 3-terminal superconductive device, an advantage is that the fabrication will be simple because a broad area can be used to attach the control electrode.

Next, an experiment that optimized the operating temperature of the superconductive device of this invention took place. The basic structure, material and method of fabricating the sample used in the experiment was the same as the 3-terminal superconductive device shown in Figure 5. However, in order to gain more marked modulation characteristics, the film of the junction was made thinner than that of the first and the second superconductive electrodes. The film thickness of the junction was from 50 nm to 150 nm. In addition, the film thickness of the first and the second superconductive electrodes was from 5 nm to 100 nm.

The critical temperature of the junction is 70K. As for distance **d**, six types of samples were fabricated, with distance **d** of 500 nm, 1000 nm, 1500 nm, 2000 nm, 2500 nm and 3000 nm. Using the samples mentioned above, the I/V characteristics of the current flowing between the first and the second superconductive electrodes was measured at more detailed operating temperature points, from 60K to 80K. For these measurements, the control electrode was put in a floating state that does not apply voltage.

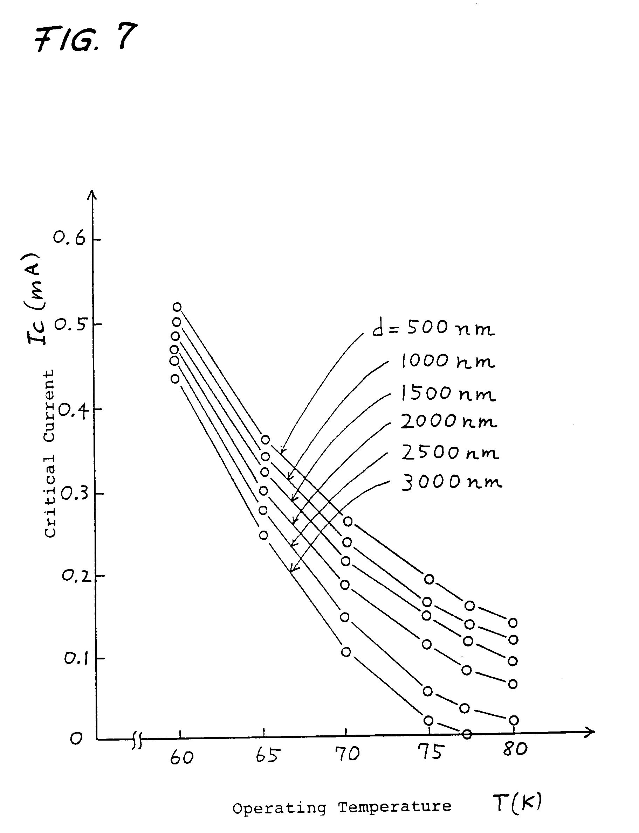

Figure 7 shows the relationship between the operating temperature and the critical current Ic that flows between the first and the second superconductive electrodes. As shown in Figure 7, if the operating temperature is about 75K or lower, that is, if the temperature is about 5K higher than the 70K critical temperature of the junction, Ic is 0.1 mA or higher even if d is 2000 nm. If d ≧ 2000 nm, it is at a value in which patterning takes place easily even with the present-day photolithography technology. Next, a sample in which d = 2000 nm was used to conduct an experiment that controlled the I/V characteristics at more detailed operating temperatures, in a range from 60K to 80K, by means of the voltage applied to the control electrode.

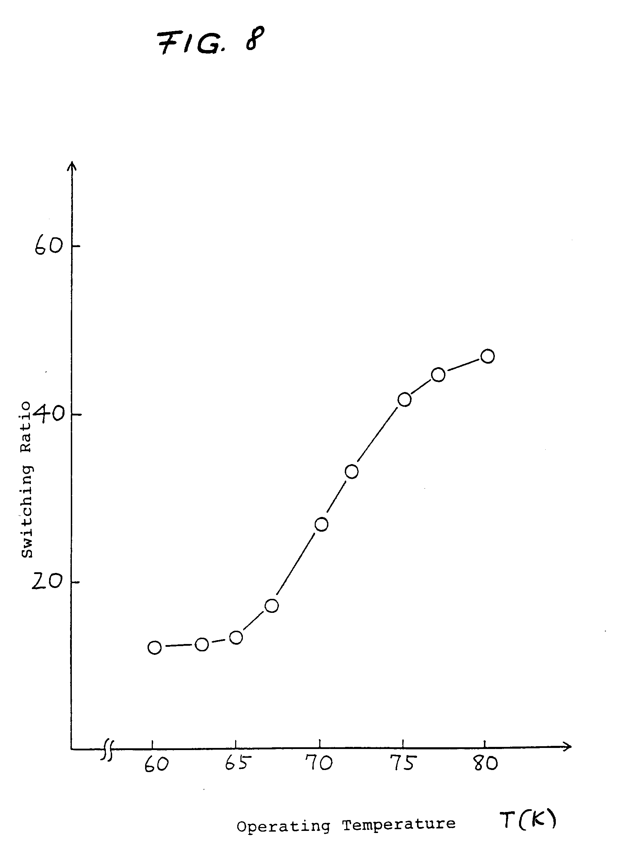

Figure 8 shows the relationship between the operating temperature and the switching ratio. The switching ratio was defined by the maximum critical current and the minimum critical current that are able to implement control by means of the control electrode voltage. As shown in Figure 8, within the measurement range, the higher the operating temperature the larger the switching ratio. With the operating temperature in the 65K vicinity in particular, that is, at a temperature that is 5K lower than the critical temperature of the junction, the switching ratio enlarges sharply. At a temperature 2K to 3K lower than the critical temperature of the junction, the switching ratio becomes 20 or more, which is a sufficiently practical value. The relationship between operating temperature and the switching ratio was evaluated for samples other than those in which d = 2000 nm. The results were almost identical to those in Figure 8.

To summarize the experiments described above, if the operating temperature is set to the critical temperature of the junction ±5K, or ideally, if set to ± 3K range, a superconductive device for which fabrication is simple and the electrical properties are excellent will be obtained. If the operating temperature is lower than the critical temperature of the junction, the critical current will be large. Therefore, the superconductive device will be suitable to fields that require large current. In the reverse case, it will be suitable to fields that require a large switching ratio.

The same types of operating temperature optimizing experiments took place for samples that used various junctions with different critical temperatures, from 60K to 70K. Junctions were fabricated under the condition of a film thickness of from 50 nm to 150 nm, and the first and the second superconductive electrodes were fabricated with a film thickness of from 5 nm to 100 nm. The result also was that if the operating temperature was set within a range of the critical temperature of the junction ±5K, excellent electrical properties were obtained. Moreover, under the conditions that the operating temperature was set within ±5K of the critical temperature of the junction, the result was that the lower the critical temperature of the junction, the larger was the switching ratio. As a result, the larger the difference between the critical temperature of the first and the second superconductive electrodes and the critical temperature of the junction, the more the switching properties improved.

In a temperature region at or lower than the critical temperature of the junction, the reasons the switching ratio is larger the closer the operating temperature is to the critical temperature of the junction are as follows. The first reason is that as the temperature increases, the carrier density of the junction decreases. The control of switching takes place due to the dielectric polarization caused by the applied voltage, which results in a modulation of the number of carriers of the junction. Therefore, even though the same number of carriers is modulated, the lower the number of carriers overall, the larger the modulation ratio. Put in other words, the larger the switching ratio. Based on this, the carrier concentration of an oxide superconductor is smaller than that of a metal superconductor. Thus, for the junction, if an oxide superconductor is used, a large modulation becomes possible, and this is convenient.

The second reason is that the superconductive state of the junction is strengthened by the penetration of the superconductive state from the first and the second superconductive electrodes. However, the level of that strength increases as the temperature decreases. If the superconductive state of the junction is strengthened, modulation will become difficult, resulting in a drop in the switching ratio. The strength or weakness of the superconductive state corresponds to the high or low of the superconductive carrier density. Thus, in that sense, the first and the second reasons are mutually related.

In the 2-terminal and 3-terminal superconductive devices described above, the critical temperature of the first and the second superconductive electrodes is higher than that of the junction. As a result of this, in a case in which the operating temperature is lower than the critical temperature of the junction, the junction will be in a superconductive state that is weaker than the first and the second superconductive electrodes. In a case in which the operating temperature is higher than the critical temperature of the junction, the junction will be in a normal conductive state that is close to the superconductive state.

Next, a description will be given concerning what inconveniences will come about should the critical temperature of the first and the second superconductive electrodes be the same as that of the junction. If the critical temperature of the first and the second superconductive electrodes and that of the junction are the same, and if the operating temperature is higher than that critical temperature, the first and the second superconductive electrodes will cease being in the superconductive state and lose their meaning as superconductive devices. On the other hand, if the operating temperature is lower than the critical temperature, such that the difference between the operating temperature and the critical temperature will be small, not only will the junction be in a weak superconductive state, so too will the first and the second superconductive electrodes.

Further, because there will be no area around it with a strong superconductive state for support, that superconductive state will be destroyed by a small disturbance from the outside. In other words, the superconductive device will have a high probability of malfunction and lack reliability.

As described above, the critical temperature of the first and the second superconductive electrodes being higher than that of the operating temperature plays an important role.

In the case of an operating temperature that is lower than the critical temperature of the junction, the junction will be in a superconductive state that is weaker than that of the first and the second superconductive electrodes. In the case of an operating temperature that is higher than the critical temperature of the junction, the state will become a normal conductive state that is near the superconductive state.

In addition to the method described above for creating a normal conductive state that is near the superconductive state, there also is a method creating a difference between the pair potential of the first and the second superconductive electrodes and the pair potential of the junction, as well as a method of creating a difference between the carrier density of the first and the second superconductive electrodes and the carrier density of the junction. These methods will be discussed below.

The basic structure of the 2-terminal superconductive device from the method of creating a difference in the pair potential is the same as the structure of the 2-terminal superconductive device shown in Figure 1. Stated in terms of the material, the substrate is made of a SrTiO₃ single crystal and the junction is a low potential superconductor made of Y_{0.87}Pr_{0.13}Ba₂Cu₃O₇₋ₓ. The first and the second superconductive electrodes are high potential superconductors made of YBa₂Cu₃O_{7-y}. With this superconductive device structure, the film thickness of the low potential superconductor, which is the junction, is from 5 nm to 100 nm. The film thickness of the high potential superconductor, which are the first and the second superconductive electrodes, is from 50 nm to 150 nm.

The method of producing this superconductive device is as follows. MBE is used to form the low potential superconductor Y_{0.87}Pr_{0.13}Ba₂Cu₃ O₇₋ₓ, which will become the junction 2, on the substrate, and MBE is used to form the high potential superconductor YBa₂Cu₃O_{7-y}, which will become the first superconductive electrode 3 and the second superconductive electrode 4. These are formed one after the other. A metal material is used as the deposition substance, and oxidation of the thin film takes place by introducing activated oxygen using an ECR plasma generation apparatus during the deposition of the film.

The critical temperatures of the low potential superconductor and the high potential superconductor were 72K and 90K, respectively. The critical temperature of the low potential superconductor can be adjusted by means of the Y site and the amount of Pr substitution. If the amount of the substitution is decreased, the critical temperature will increase. If the amount of the substitution is increased, the critical temperature will drop. The lattice constants of these two types of superconductors are almost identical. Thus, from the point of view of thin film epitaxial growth technology, this is very convenient.

After forming the low potential superconductor and the high potential superconductor consecutively on the substrate, etching takes place by means of photolithography to obtain the 2-terminal superconductive device with the structure shown in Figure 1. Although not illustrated, a protective film is formed on the surface area, except for the output electrode, for preventing deterioration.

When the I/V characteristics of the superconductive device that was obtained was measured, the RSJ characteristics shown in Figure 3 were observed. The measurement temperature was 70K, and cooling took place using a Solvay freezer. Distance **d** between the first and the second superconductive electrodes was changed from 200 nm to 9000 nm and the I/V characteristics were checked. All showed definite RSJ characteristics.

The structure of the 3-terminal superconductive device from the pair potential method of creating a difference is the same as the structure of the 3-terminal superconductive device shown in Figure 5. The substrate, low potential superconductor and high potential superconductor materials and production method are exactly the same as those of the 2-terminal superconductive device of the previously described pair potential method of creating a difference.

The control electrode voltage dependency of the I/V characteristics of the superconductive device are identical to the properties shown in Figure 6. It is actually discernable that the I/V characteristics can be controlled by the voltage applied to the control electrode. The reason this kind of control is possible is that the dielectric 4 is polarized by the applied voltage, resulting in the modulation of the carrier of the low potential superconductor 2. If an oxide superconductor is used as the low potential superconductor, because the oxide superconductor carriers are fewer than metal superconductors, a large modulation is possible, and this is convenient.

With this superconductive device, because the pair potential on the side of the first and the second superconductive electrodes is higher than that of the junction, the superconductive state of the junction becomes stable. Thus, a superconductive device that is strong against disturbances such as thermal noise can be obtained. Moreover, the switching time becomes high speed, because it is possible to restrain the CR time constant.

Table 2 shows the switching ratios of the superconductive device and a comparison example in which the first and the second superconductive electrodes and the junction are formed of the same superconductive materials. The critical temperature of the superconductor in the comparison example is 90K. What is clear from Table 2 is that by combining the first and the second superconductive electrodes and the junction using a superconductor with different pair potentials and by lowering the pair potential of the junction, the switching ratio will increase. In other words, the superconductive device becomes highly controllable and stable.

**Table 2**

| | Embodiment | Comparison |
|---|---|---|
| Switching ratio | 18 | 8 |

If this invention is applied to such a 3-terminal device and a plurality of control electrodes is formed, multiple-objective applications become possible, just as with dual-type transistors.

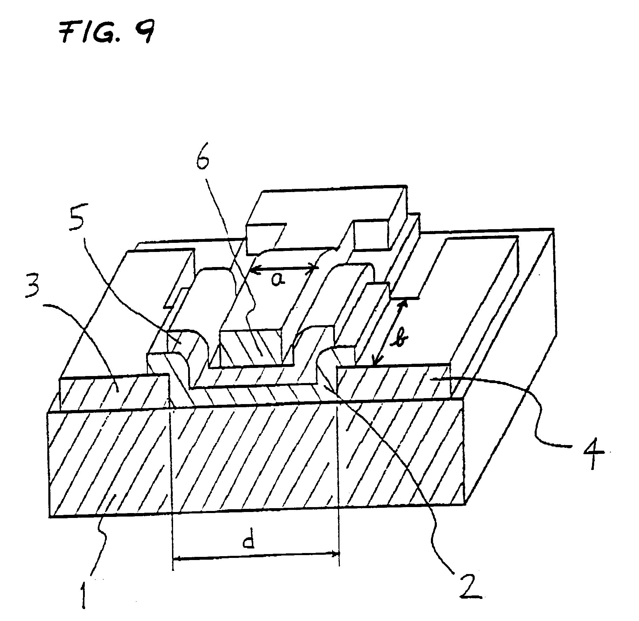

Figure 9 shows an angular cross section of a 3-terminal superconductive device from the method creating a difference in the carrier density. The superconductive device is formed from a substrate 1, a junction 2, the first superconductive electrode 3, the second superconductive electrode 4, a dielectric 5 and a control electrode 6.

The major points in the processing and the materials used to fabricate this superconductive device are as follows. First, a YBa₂Cu₃O₇₋ₓ type oxide superconductive thin film of 50 nm to 100 nm is formed on top of the substrate 1, which is made of SrTiO₃ single crystal. The critical temperature of this YBa₂Cu₃O₇₋ₓ film is 90K. If the material is such that it does not react much with the superconductive thin film and has a good lattice constant compatibility, the substrate does not have to be limited to SrTiO₃.

After forming the superconductive thin film, patterning takes place using photolithography to obtain the first superconductive electrode 3 and the second superconductive electrode 4 at the same time. Next, a 5 nm to 10 nm La₂₋ₓSrₓCuO₄ type superconductor is formed and patterned to obtain the junction 2. Therefore, the adjustment of the carrier density is promoted by adjusting the value of x. Table 3 shows the carrier density of samples in which the value of x was adjusted. The carrier density was calculated from the results measured from the Hall effect of the film obtained.

Although that value agreed with the value estimated from the amount of the Sr substitution in a semi-quantitative manner, it did not reach agreement quantitatively. The reason for that is believed to be in the fact that the oxygen concentration is removed from the stoichiometric composition in correspondence with the amount of the Sr substitution. Next, the dielectric 5 and the control electrode are formed and patterned.

**Table 3**

| Sample no. | Carrier density (1/cm³) |
|---|---|
| Embodiment 1 | 8 x 10¹⁹ |
| Embodiment 2 | 3 x 10²⁰ |
| Embodiment 3 | 6 x 10²⁰ |
| Embodiment 4 | 9 x 10²⁰ |
| Comparison 5 | 5 x 10²¹ |
| Comparison 6 | 8 x 10²¹ |
| Comparison 7 | 9 x 10¹⁹ |

**Table 4**

| Sample no. | Switching ratio | Evaluation |
|---|---|---|
| Embodiment 1 | 28 | Good |
| Embodiment 2 | 65 | Excellent |
| Embodiment 3 | 53 | Excellent |
| Embodiment 4 | 30 | Good |
| Comparison 5 | 17 | Fair |
| Comparison 6 | 15 | Fail |
| Comparison 7 | 12 | Fail |

The superconductive device was fabricated by means of the preceding processes and the switching ratios of that superconductive device were examined. Table 4 shows the results along with comparison examples in which the carrier densities are not suitable values. The measured temperature is a temperature that is 3K lower than the critical temperature of the channel superconductor. Comparison 5 is the sample in which the critical temperature is the highest.

The evaluations that also appear in Table 4 followed the following criteria. The switching ratio that can be applied in practical terms was considered to be 20 or higher. That value was considered the target value. If the switching ratio was at the target value or higher, it was rated as good. When it was 30 or higher, the determination was that it was quite good and that was rated as excellent. When the switching ratio fell below 20, it was basically rated as a fail. However, if it was close to 20, it was rated as fair.

From Table 3 and Table 4, we know that in order to obtain good switching properties, it is necessary to hold down the junction 2 carrier density to within a specified range and that the carrier density range is from 10¹⁹ to 10²⁰, and even more desirable from 1 x 10²⁰ to 9 x 10²⁰/cm³. As for the relationship between the carrier density and the switching ratio, initially, the switching ratio rises as the carrier density falls. However, when it enters the 10¹⁹/cm³ level, conversely, the switching ratio tends to drop. This is believed to be due to the creation of an unstable junction 2 superconductive state when the carrier density is too small. This is in spite of making the modulation of the carrier density easier by holding down the carrier density.

The switching ratio evaluation becomes a fail when the carrier density is lower than the 2 x 10¹⁹/cm³ level. That is, if it is at 2 x 10¹⁹/cm³ when at the 10¹⁹/cm³ level, the switching properties can be obtained. Thus, it can be stated that for a drop in the switching ratio, the switching properties in which the superconductive carrier was in control become the properties in which the proximity effect is in control and in which the freedom in size (the distance between the first superconductive electrode 3 and the second superconductive electrode 4) has been lost.

In addition, because the adjustment of the carrier density of the superconductive device, takes place by changing the composition ratio of the junction 2, it is possible to for this to take place very easily, without adding another production step.

Next, another example of the 3-terminal superconductive device from creating a difference in the carrier density will be described. The points that differ between this superconductive device and the one in the previous embodiment is that a Nd Ba₂ Cu₃ O_{7-y} type superconductor is used for the first and the second superconductive electrodes. In addition, for the adjustment of the junction carrier density, Nd, which is a trivalent element, is substituted with Tr, which is quadrivalent, allowing the use of a Nd₁ₓPrₓBa₂Cu₃O_{7y} type superconductor. Table 5 shows the carrier density of the samples that were fabricated.

**Table 5**

| Sample no. | Carrier density (1/cm³) |
|---|---|
| Embodiment 1 | 7 x 10¹⁹ |
| Embodiment 2 | 3 x 10²⁰ |
| Embodiment 3 | 6 x 10²⁰ |
| Embodiment 4 | 9 x 10²⁰ |
| Comparison 5 | 4 x 10²¹ |
| Comparison 6 | 9 x 10²¹ |

The reason that Pr was selected is because it is the same type of rare earth element as Nd. Moreover, it also was because its properties are similar and its ion radius is close, which restrains as much as possible changes in its lattice constant and allows adjustment of the carrier density. Depending on the combination and types of superconductive component elements, a number of substitute elements can be selected. However, as is well known, it is necessary to consider the point that the critical temperature of the superconductor is greatly influenced by the lattice constant. In addition to this, the adjustment of the carrier density of a NdBa₂Cu₃O_{7-y} type superconductor also is possible through the method of controlling the content of oxygen. However, this is not suitable for the precise control of the carrier density.

The switching ratio of the superconductive device obtained was examined. The results are indicated in Table 6 along with comparison examples that are not suitable values for the carrier density. Comparison number 5 is that of the sample in which the critical temperature of the junction was the highest. The first and the second superconductive electrodes and the junction are made of the same composition. The criteria for the evaluation that also is indicated in Table 6 are the same as those for Table 4. As shown in Table 6, this superconductive device has an obvious improvement in the switching ratio compared to the comparison example. Based on this result, the carrier density range in which good switching properties ca be obtained is from 10¹⁹ to 10²⁰/cm³. More desirable, it is from 3 x 10²⁰ to 6 x 10²⁰/cm³.

**Table 6**

| Sample no. | Switching ratio | Evaluation |
|---|---|---|
| Embodiment 1 | 20 | Good |
| Embodiment 2 | 43 | Excellent |
| Embodiment 3 | 30 | Excellent |
| Embodiment 4 | 21 | Good |
| Comparison 5 | 15 | Fail |
| Comparison 6 | 13 | Fail |

As is the case for this superconductive device, when superconductors (here, the first and the second superconductive electrodes) in which the carrier density is higher than both ends of the junction and in which the pair potential is high are formed on both ends of the junction, the critical temperature of the junction showed a tendency to be markedly higher when the critical temperature of the junction was measured as a single unit. This is believed to be due to the pair potential of the junction being pulled up by the surrounding superconductors. If such a characteristic is utilized, it is possible to use the junction at a higher temperature than the type that uses the superconductive device with the junction as a single unit. Depending on the situation, even if a temperature higher than the critical temperature of the junction is used, it is possible to maintain the junction in the superconductive state. In addition, another characteristic is that the stability and repeatability of the properties are higher than when using the junction as a single unit.

In the preceding description, the carrier density was described by using two examples of methods that substitute elements with different composition ratios and [values]. However, as substitute elements, in addition to those given above, Ce, Tb, Bi, Sb, Pb, Tl, Ag, K, Rb and Cs also may be used. Moreover, in addition to these methods, it also is possible to use a method that substitutes the Cu site of the Cu-O bond in which either a positive hole or an electron is introduced directly by another element. As the substitute elements of the conductive layer Cu site, it is possible to use Ti, Zr, Hf. V, Nb, Ta, Cr, Mo, W, Mn, Fe, Co, Ni and Zn, which have a difference in bonding energy with the oxygen 2p [orbit]. Further, these methods may be used in combination.

In the description above of the superconductive device from the methods that create a difference in the carrier density, only the 3-terminal superconductive device was taken up. However, it goes without saying that the methods of creating a difference in carrier density can itself be applied as is to the 2-terminal superconductive device.

Next, a superconductive device that uses for the first and the second superconductive electrodes and the junction superconductors that differ in terms of crystallography will be described. Its basic structure is the same as the structure of the 3-terminal superconductive device shown in Figure 5. As superconductor combinations that differ in terms of crystallography, the following three types, which will be discussed below, were selected and samples of each were fabricated.

The superconductive device from the first combination is composed of a junction, which is made of a YBa₂Cu₄O₈ superconductor that is formed on top of a substrate that is made of a SrTiO₃ single crystal, composed of the first and the second superconductive electrodes, which are made of a YBa₂Cu₃O_{7-y} (0 ≦ y < 0.2) superconductor that in terms of crystallography is different from the said junction, composed of a dielectric that is formed on top of the junction, and composed of a control electrode 5. Things such as the switching and the amplification of this superconductive device take place by changing the carrier density inside of the junction through the dielectric and control electrode and controlling the value of the critical current.

As for fabrication, MBE is used to form the YBa₂ Cu₄ O8 that makes up the junction and the YBa₂Cu₃O_{7-y} (0 ≦ y < 0.2) that makes up the first and the second superconductive electrodes in the same chamber and consecutively. A metallic substance is used for the deposition material. The oxidation of the thin film takes place by introducing activated oxygen from the ECR plasma generating apparatus during the formation of the film. Next, the first and the second superconductive electrodes are formed by etching the YBa₂Cu₃O_{7-y} (0 ≦ y < 0.2) thin film using photolithography and then patterning it. Finally, the dielectric and the control electrode are placed between the first and the second superconductive electrodes to obtain the superconductive device.

The critical temperatures of the first and the second superconductive electrodes used here were 70K and 90K, respectively.

The superconductive device from the second combination has the same structure as the superconductive device of the first combination and uses a Bi₂Sr₂Ca₂Cu₃O_{y} type superconductor to fabricate the first and the second superconductive electrodes and uses a Bi₂Sr₂₁CaCu₂O_{y} (sometimes Pb is substituted for some of the Bi) type superconductor to fabricate the junction, which is a superconductor that differs from the first and the second superconductive electrodes in terms of crystallography.

The superconductive device from the third combination has the same structure as the superconductive device of the first combination and uses a YBa₂Cu₃O_{7-y} (0 ≦ y < 0.2) type superconductor to fabricate the first and the second superconductive electrodes and uses a Bi₂Sr₂Ca₂Cu₃ Oy (sometimes Pb is substituted for some of the Bi) type superconductor to fabricate the junction. In the case of the superconductor devices of the first and the second combinations, the superconductive thin films that become the first and the second superconductive electrodes and the junctions were formed inside of the same chamber. However, in the case of the superconductive device of the third combination, these were formed separately using two MBE apparatuses. However, the two MBE apparatuses were connected and configured so that the films could be formed in succession without exposure to the atmosphere.

Ten units each were fabricated of the superconductive devices of the first to the third combination mentioned above and the I/V characteristics at the specified control voltages were measured. The measurements took place in a helium gas atmosphere at a junction critical temperature of 2K. The first variations and the critical current values of each of the ten samples and five repeated measurements were taken and the repeatability (fluctuation) was examined. Among these, the fluctuation rate was considered to be the value from dividing the average value of the amount of fluctuation when the amount of fluctuation was measured at its greatest by means of the average of the critical current. Examples of the prior art from changing the first variation, fluctuation rate and Y-type oxygen content and adjusting the critical temperature are shown in Table 7.

As can be understood from Table 7, the crystal structure in the superconductive devices from the first to the third combinations are different, and there is a marked improvement in stability and reliability due to combining superconductors that have a stable superconductive state. This is due to a reduction in fluctuation factors and the restraint of electro-migration. These values require additional improvements to reduce them further. Moreover, although it is possible to reduce them further, as stated before, even if the technology advances in the future, the number of destabilizing factors are larger in the technology of the prior art than in the superconductive devices from the first to the third combinations. Thus, it is not likely that the values of both will be reversed.

**Table 7**

| | 1st variation | Fluctuation rate (repeatability) |
|---|---|---|
| 1st combination | 21% | 22% |
| 2nd combination | 18 | 16 |
| 3rd combination | 16 | 17 |
| Prior art | 71 | 54 |

In the preceding description of the superconductive device that uses superconductors that are different in terms of crystallography for the first and the second superconductive elements and for the junction, only the 3-terminal superconductive device was discussed. However, it goes without saying that this method itself can be applied as is to the 2-terminal superconductive device as well.

### Potential Industrial Uses

As indicated above, because it is easy to fabricate the superconductive device of this invention, it is valuable as a high yield, highly reliable superconductive device. In particular, when used as a 3-terminal superconductive device, the switching characteristics are excellent. Therefore, it is suitable to the switching devices of the logic circuits for which high speed and low power consumption are demanded.

## Claims

1. A superconductive device comprising:
a first superconductive electrode;
a second superconductive electrode; and
a junction that connects these superconductive electrodes, wherein the junction is formed from a superconductive material and the junction is in a superconductive state that is weaker than the superconductive state of the first and the second superconductive electrodes.

2. The superconductive device of claim 1, wherein a control electrode is formed adjacent to the junction and the junction is used as a channel.

3. The superconductive device of claim 1 or claim 2, wherein the critical temperature of the junction is lower than the critical temperature of the first and the second superconductive electrodes and the operating temperature is set to a temperature that is lower than that of the first and the second superconductive electrodes.

4. The superconductive device of claim 3, wherein the operating temperature is set within a temperature range that is the critical temperature of the junction ±5K.

5. The superconductive device of claim 1 or claim 2, wherein the carrier density of the junction is smaller than the carrier density of the first and the second superconductive electrodes.

6. The superconductive device of claim 1 or claim 2, wherein the magnitude of the pair potential of the junction is smaller than the magnitude of the pair potential of the first and the second superconductive electrodes.

7. The superconductive device of claims 1 through 6, wherein the junction, the first superconductive electrode and the second superconductive electrode are made of oxide superconductive materials.

8. The superconductive device of claim 7, wherein the crystal structure of the junction is different from the crystal structure of the first and the second superconductive electrodes.

9. The superconductive device of claim 7 or claim 8, wherein the carrier density of the junction is from 10¹⁹ to 10²⁰/cm³.

10. The superconductive device of claim 9, wherein the carrier density of the junction is adjusted by means of an element that has a superconductor composition and the composition ratio of the element introduces either electrons or holes, or, it is adjusted by means of an element that does not have a superconductor composition but introduces either electrons or holes and makes adjustments through substitution with elements with different values.
